# EUROPEAN PATENT APPLICATION

(11) **EP 2 088 671 A2**
(43) Date of publication of application: **12.08.2009**
(21) Application number: 09152115.3
(22) Date of filing: 05.02.2009
(51) Int. Cl.: H03F 3/217

(54) **Amplifier device and system using the device**

(30) Priority: 06.02.2008 IT MI20080183
(71) Applicant: STMicroelectronics S.r.l., 20041 Agrate Brianza (MI) (IT)
(72) Inventor: Guanziroli, Federico, 20030 Lentate sul Seveso, Milano (IT); Nicollini, Germano, 29100 Piacenza (IT)
(74) Representative: Leihkauf, Steffen Falk

(57) **Abstract**

The invention relates to a device (100) comprising: an input for an electric signal (vₑ(t)); an integrator stage (101) connected to said input to provide an integrated signal (vᵢₙₜ(t)); an amplifier stage (300) electrically coupled to the integrator stage (101) to receive said integrated signal (vᵢₙₜ(t)) and to provide an output signal (vₒₜₜ(t)). The device being **characterized in that** the integrator stage (101) is such that the integrated signal is obtained by an individual signal integration operation.

## Description

The object of the present invention is an electronic amplifier device, particularly of the class D type. More particularly, the present invention relates to a class D and closed loop amplifier.

In recently designed electronic amplifiers, in particular in audio amplifiers which can be used in battery-supplied portable apparatuses, the need is felt to introduce output stages of the class D type in place of the conventional AB class output stages.

As known to those skilled in the art, the class D output stages comprise at least one N-MOS transistor and one P-MOS transistor, having the respective gate and drain terminals mutually connected in an inverter configuration. Furthermore, such transistors act as a switch to take in an alternate manner a conduction (ON) or interdiction (OFF) status. In particular, when one of such transistors is turned off (and the other one is turned on), the current which passes through it is equal to zero, while when such transistor is turned on (and the other one is turned off), the voltage drop on it is small, ideally null.

In each case, the condition of non-concomitant conduction of the transistors of the output stage of a class D amplifier (except for the short time intervals during the ON-OFF switchings) ensures a reduced power dissipation. Therefore, the class D amplifier has a higher efficiency than that of a class AB, while keeping the available power provided to a load constant.

In addition, the reduced power dissipation of the class D amplifier ensures a higher duration of the supply batteries in the portable devices, as well as a lower overall overheating of the amplifier integrated circuit and an increase of the reliability thereof.

Generally, for audio applications class D closed loop amplifier devices are used. The functioning principle of a class D closed loop amplifier is described in "The Class-D Amplifier" from the book Introduction to Electroacustic and Audio Amplifier Design, Second Edition - Revised Printing, by W. Marshall Leach, Jr., published by Kendall/Hunt, 2001.

The known and actually employed circuits comprise more input integrators, a comparator, a driving circuit triangular wave generator, and an output power stage. The input signal compares to the feedback, and the thus-obtained error signal (representative of a difference in the compared signals) is integrated and then compared to the triangular wave. Finally, the resulting modulated PWM signal in output from the comparator suitably processed by the driving circuit controls the output power stage.

The known solutions utilize from two to four integrators before the comparator. The reason is that by increasing the number of integrators, the loop gain at low frequencies increases and, as known to those skilled in the art, this involves a higher rejection to the low frequency noises, such as those coming from the supplies, and a higher reduction of the distortions introduced by both the output stage and the non-linearity of the triangular wave. In particular, these noises decrease as the number n of integrators increases, therefore as the filtering order increases. On the contrary, the consumption is more and more increased as the number n of integrators increases.

The Applicant has noticed that the currently implemented known amplifiers have a distortion shape which is not taken into account according to the

### prior art.

Object of the present invention is to devise and provide a device allowing at least partially obviating the drawbacks specified herein before with reference to the prior art.

Such object and such tasks are reached by a device in accordance with claim 1. Particular embodiments of the device are described by the dependant claims 2-18.

It is the object of the present invention also an electronic system in accordance with claim 19.

Further characteristics and the advantages of the device according to the invention will be more clearly understood from the description reported herein below of preferred exemplary embodiments, given by way of indicative and non-limitative example, with reference to the annexed figures, in which:
- Fig. 1 illustrates an example of an electronic system in accordance with a first embodiment of the present invention;
- Fig. 2 illustrates an example of an amplifier device in binary configuration which is employable in said system;
- Fig. 3 illustrates an example of an output amplifier stage employable in said device;
- Fig. from 4 shows an example of an amplifier device in ternary configuration;
- Fig. 5 illustrates behaviours of an amplifier device in accordance with an embodiment of the invention, and an amplifier device of the prior art.

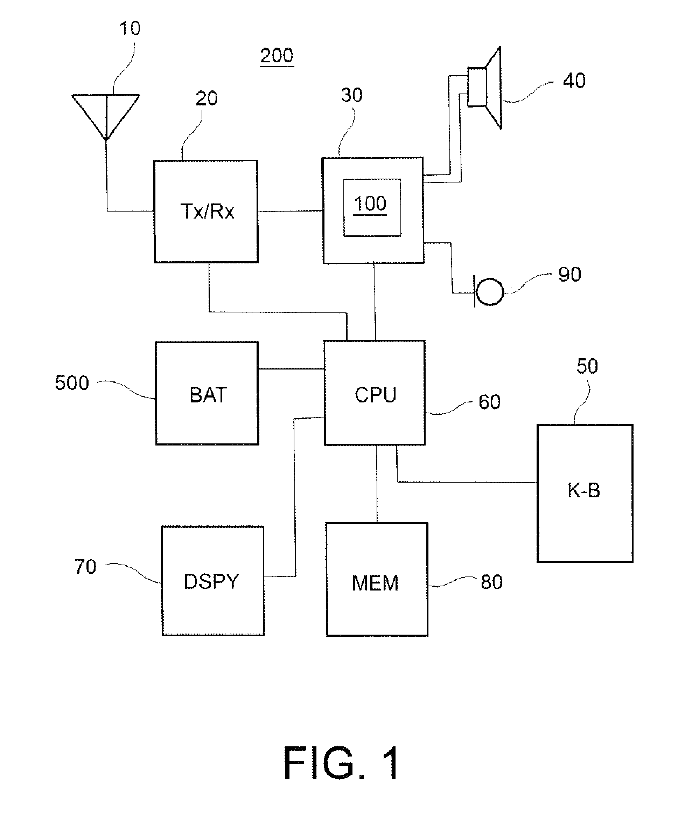

Fig. 1 shows an electronic system 200 in accordance with an exemplary embodiment of the invention. For example, the electronic system 200 is a battery-supplied portable apparatus such as, particularly and without being limited to, a mobile telephone comprising an antenna 10, a transceiver stage 20 (Tx/Rx) coupled to the antenna 10, an audio unit 30 connected to the transceiver stage 20. A loudspeaker 40, and a microphone 90 are connected to the audio unit 30.

The mobile telephone 200 is also provided with a control and processing unit 60 (CPU) for the management of several functions and, in particular, for the management of the transceiver stage 20 and the audio unit 30, according to a control program stored in a system memory 80.

Furthermore, the mobile telephone 200 is provided with a screen or display, and a user interface such as an alphanumeric keypad 50 (K-B). The mobile telephone 200 comprises a battery 500 intended to provide a supply electrical voltage of the different blocks included in the same telephone.

The audio unit 30 comprises, among the other ones, also an amplifier device 100, according to the example, of the audio type, which allows bringing to a suitable power level the audio signal to be supplied to the loudspeaker 40.

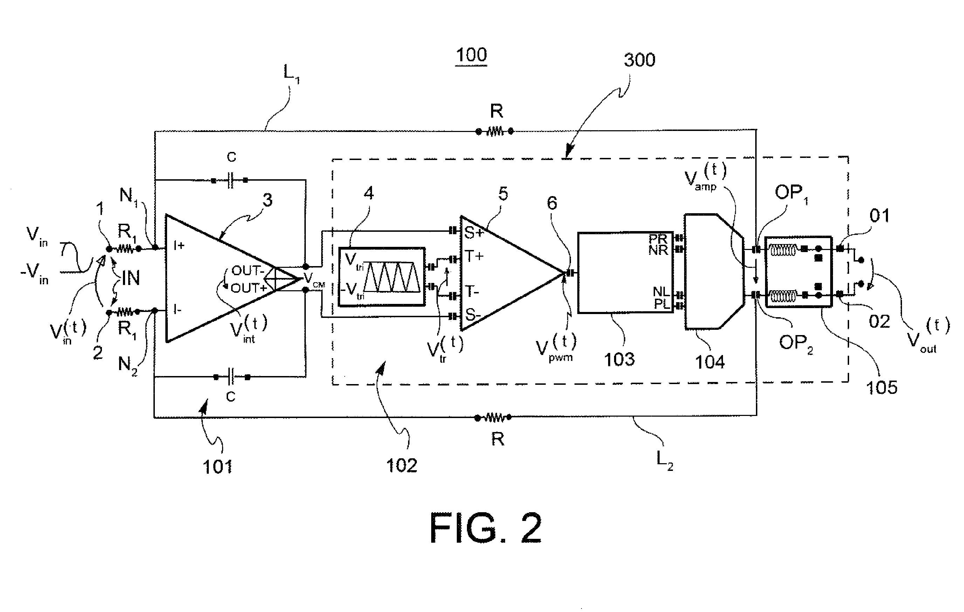

Fig. 2 shows an exemplary embodiment of the amplifier device 100. The amplifier device 100 is, in particular, of the class D, and is of the feedback type, so as to take a closed loop configuration. Furthermore, the amplifier device 100 of Fig. 2 is of the binary type.

The amplifier device 100 comprises, on a main or "outward" line, a feedback loop, an input IN for an input audio electrical signal vᵢₙ(t), an integrator stage 101 connected to the input IN, and an amplifier stage 300 electronically coupled to the integrator stage. In particular, the amplifier stage 300 comprises a PWM (Pulse Width Modulation) modulator 102, a driving circuit 103, an output amplifier 104, and a filtering stage 105. For example, the input audio electrical signal vᵢₙ(t) has a frequency ranging between 20 Hz and 20 kHz.

Advantageously, the amplifier stage 300 on the whole is such as to produce a distortion on an output signal vₒᵤₜ(t), in the case such stage 300 is an open loop one, which is below 0,2% and, more preferably, below 0.1%.

In particular, the input IN includes a first terminal 1, and a second terminal 2, between which the input electrical signal vᵢₙ(t) is applicable such as, for example, an electrical voltage variable between a positive peak vᵢₙ and a negative peak -vᵢₙ. To the first and the second terminals 1 and 2, a first resistance R1 is respectively associated.

The integrator stage 101 shown in Fig. 2 comprises an individual integrator. In particular, such integrator stage 101 comprises an operational amplifier 3, provided with a non-inverting input "I+" connected to the first terminal 1 through such first resistance R₁, and an inverting input "I-" connected to the second terminal 2 through a similar resistance R₁.

Such operational amplifier 3 is of the differential output type, and is provided with an inverting output terminal OUT- and a non-inverting output terminal OUT+. It shall be noted that the operational amplifier 3 of the integrator stage 101 is feedbacked by a capacitor C connected between the inverting output OUT- and the non-inverting input "I+", and by another capacitor C connected between the non-inverting output OUT+ and the inverting input "I-". In other terms, the above-mentioned integrator stage 101 generally comprises the operational amplifier 3, the capacitors C, and the first resistances R₁.

An integrated signal vᵢₙₜ(t) present between the output terminals OUT+ and OUT- (that is, the difference of the signals present at said output terminals) is representative of the integration of the difference between the input signal vᵢₙ(t) and the feedback signals present on output nodes OP1 and OP2, that is, the signal vₐₘₚ(t). Furthermore, the operational amplifier 3 can be also provided with a common mode input terminal CM adapted to fix the common mode voltage of the outputs.

The PWM modulator 102 is adapted to provide on an output terminal 6 of its own a modulated signal v_{PWM}(t) comprising a train of width-modulated pulses, in which the pulses width is dependant on the trend of the signal exiting the integrator stage 101.

According to a particular embodiment, the PWM modulator 102 comprises a generator 4 of triangular wave signal vₜᵣ(t), and a comparator 5. The comparator 5 is adapted to perform a comparison between the electrical signal provided by the operational amplifier 3 and the triangular wave signal.

The triangular wave generator 4 can be of a known type such as, for example, that described in EP-A-1788704 with reference to the respective Figures 1 and 2, and herein incorporated as a reference. Furthermore, it shall be noticed that the triangular signal vₜᵣ(t) has typically a higher frequency than that of the input signal vᵢₙ(t). For example, the input signal vᵢₙ(t) has a frequency of about 20 kHz, the triangular signal vₜᵣᵢ(t) has a frequency of about 250 kHz.

Furthermore, the triangular wave generator 4 has a high linearity of the triangular wave provided. In particular, the generator 4 has a non-linearity such as to produce a distortion on the output signal vₒᵤₜ(t) in the case it has an open loop structure, below 0.2%, and preferably below 0.1%.

For example, the triangular wave generator described in EP-A-1788704 gives a high linearity and, therefore, a low distortion, thus allowing obtaining the distortion values indicated above.

The comparator 5 is, for example, an open loop operational amplifier which is provided, according to the particular embodiment shown in Fig. 2, with differential inputs. In particular, the comparator 5 comprises first differential input terminals S+ and S- connected to the outputs OUT- and OUT+ of the operational amplifier 3 in order to receive the integrated signal vᵢₙₜ(t).

Furthermore, second differential input terminals T+ and T- of the comparator 5 are connected to the generator 4 in order to receive the triangular wave signal vₜᵣ(t), with a peak-peak width equal to 2Vₜᵣᵢ.

It shall be noted that the comparator 5 is implementable, for example, by cascade connecting two or more amplification stages. For example, the comparator 5 comprises three amplification stages (not shown in Fig. 2) of which: a first stage is provided with two differential inputs and with one differential output; a second stage comprises differential input and output; a third stage is provided with a differential input and with a single output (single ended). Such stages are implemented through circuit structures which are known to those skilled in the art.

The driving circuit 103 can be of a type known to those of ordinary skill in the art, and is such as to provide to the output amplifier 104 first NR, PR and second NL, PL activation signals. The driving circuit 103 is such as to perform a processing of the modulated PWM signal v_{PWM}(t) to send the above-mentioned activation signals to the output amplifier 104. The function of the driving circuit 103 will be more clearly understood from the following description of an exemplary embodiment of the amplifier 104.

With reference to the output amplifier 104, this is such as to have a low distortion and, in particular, is such as to produce a distortion on the output signal vₒᵤₜ(t) in the case it has an open loop structure below 0.2%. Preferably, such distortion value is below 0.1%.

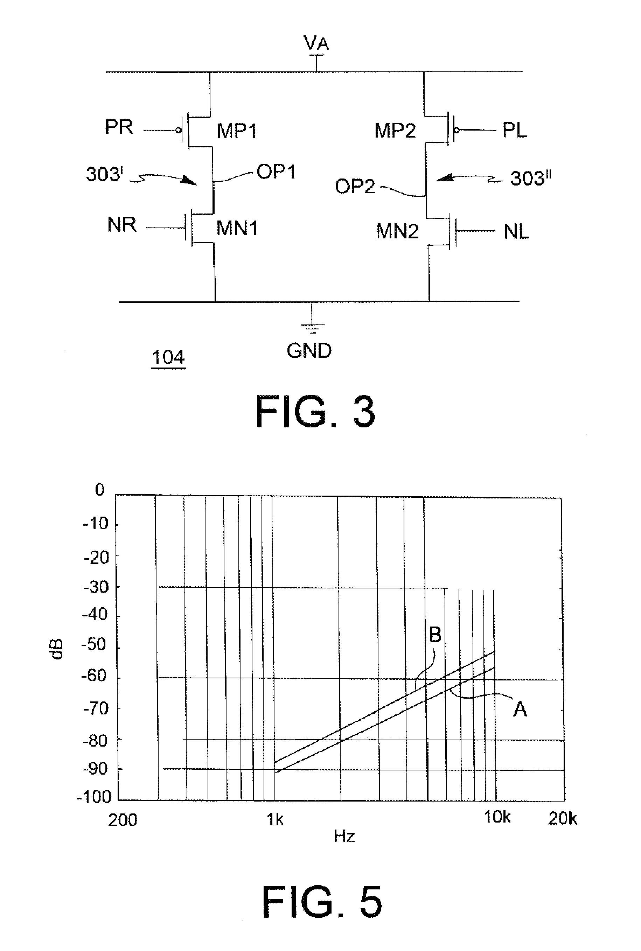

In this regard, Fig. 3 shows an example of the output amplifier 104 of the class D type which operates as a power stage. Such output amplifier 104 comprises a first 303' and a second 303" devices of the inverting type, each of which is connected between a supply potential V_{A} and a ground potential GND. Furthermore, the first inverting device 303' comprises first transistors MN1 (for example, of the N-MOS type) and MP1 (for example, of the P-MOS type) mutually connected through a respective drain terminal.

Similarly, the second inverting device 303" comprises second transistors MN2 (for example, of the N-MOS type) and MP2 (for example, of the P-MOS type) mutually connected through the respective drain terminals.

It shall be noticed, in particular, that the drain terminals of such first MN1, MP1 and second MN2, MP2 transistors are the first output terminal OP1 and the second output terminal OP2 of the same output amplifier 104, respectively (also indicated in Fig. 2). Furthermore, the four gate terminals of the above-mentioned first MN1, MP1 and second MN2, MP2 transistors are the inputs of the output amplifier 104.

The first transistors MN1, MP1 of the output amplifier 104 are controllable in conduction or interdiction through the respective first activation signals NR and PR generated by the driving circuit 103. Similarly, the second transistors MN2, MP2 are controllable in conduction or interdiction through the respective second activation signals NL and PL.

It shall be noticed, in particular, that the first NR, PR and the second NL, PL activation signals are signals of a digital type, that is, they may take only two different values corresponding to two different logic levels: a high logic level (for example, equal to the supply potential V_{A}), and a low logic level (for example, equal to the ground potential GND).

Under operative conditions, the first activation signals NR and PR always take the same values, therefore if one of the first transistors MN1, MP1 is in conduction, the other one results to be interdicted. Similar considerations apply for the second activation signals NL, PL and the respective second transistors MN2, MP2.

It shall be further noticed that the values taken by the first NR, PR and the second NL, PL activation signals are such that the first P-MOS transistor MP1 concomitantly conduces to the second N-MOS transistor MN2 and, vice versa, the first N-MOS MN1 concomitantly conduces to the second P-MOS MP2.

Furthermore, advantageously, the driving circuit 103 ensures a suitable phase displacement of the above-mentioned first NR, PR as well as the second activation signals NL, PL. In such manner, the concomitant conduction (conduction overlap) of both the first transistors MN1, MP1 (or both the second MN2, MP2) is avoided, thus ensuring a high efficiency of the output amplifier 104.

The class D output amplifier 104 represented by way of example in Fig. 2 and, therefore, the whole amplifier device 100, is of the binary type, that is, is such that a differential output signal vₒᵤₜ(t) taken at the output terminal OP1 and OP2 can take only two possible values, for example, +V_{A} and -V_{A}, for any values (positive or negative) of the input signal vᵢₙ(t).

The first output terminal OP1 of the output amplifier 104 is connected, through a first feedback conductive line L1 including a first resistor R, at a first node N1 of the first input terminal 1. The second output terminal OP2 of the output amplifier 104 is connected, through a second feedback conductive line L2 including a second resistor R (for example, having resistance equal to that of the first resistor), at a second node N1 of the second input terminal 2.

The filtering stage 105 is implementable with a low-pass filter, for example of the LC type, and it has input terminals connected to the first and second outputs OP1 and OP2 of the output amplifier 104. The filter 105 has respective output terminals O1 and O2 connected to a user load such as, according to the described example, the loudspeaker 40 shown in Fig. 1.

The filter 105 allows sending to the loudspeaker 40 only one low frequency component of an amplified audio signal vₐₘₚ(t) which is present in output from the output amplifier 104, eliminating the noise components at the higher frequencies.

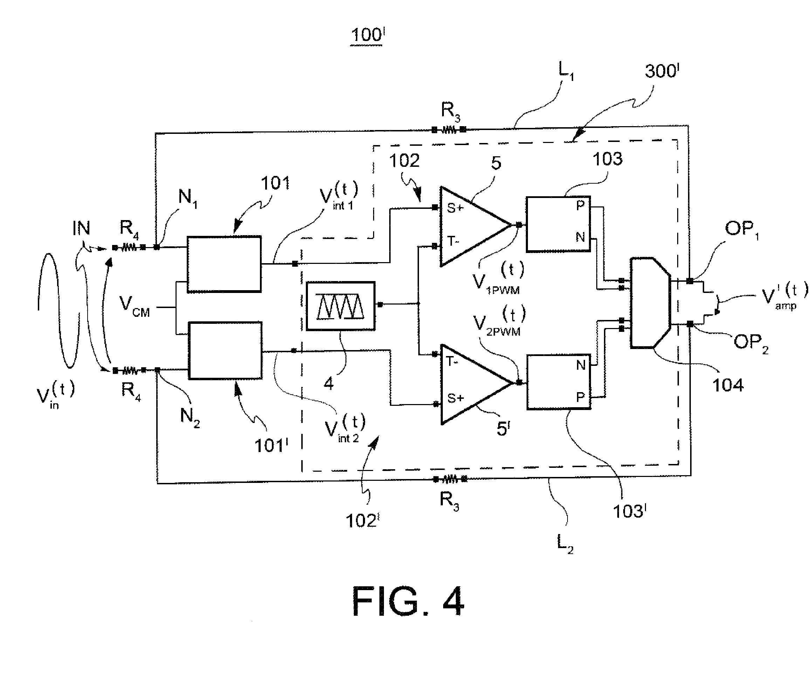

It shall be noted that, although the previous description has referred to a solution of the binary type, the teachings of the invention are valid also for an amplifier device of the ternary type. Fig. 4 schematically shows an amplifier device 100' of the ternary type, and comprising some blocks similar to those described with reference to Fig. 2, and which therefore have been shown in Fig. 4 with the same reference numerals.

As it shall be apparent to those skilled in the art, the amplifier device of the ternary type 100' comprises along a first branch: an integrator circuit 101, a triangular wave generator signal 4, a comparator 5, a driving circuit 103, and an output amplifier 104 of a type which is similar to those described above with reference to Figures 2 and 3. Besides these circuital blocks, the amplifier device 100' of the ternary type is also provided along a second branch with: a further integrator circuit 101', a further comparator 5', and a further driving circuit 103, similar to those of the first branch.

It shall be noted that each of the integrator circuits 101 and 101' is capable of performing only one integration operation of the relative input signal and, for example, each of the circuits 101 and 101' is implementable through an individual operational amplifier configured as an integrator similar to that shown in Fig. 2. The integrator circuit 101 provides a first integrated signal vᵢₙₜ₁(t), and the further integrator circuit 101' provides a second integrated signal vᵢₙₜ₂(t).

Again, in relation to the ternary configuration of Fig. 4, through the first modulated signal v_{1PWM}(t) and the second modulated signal v_{2PWM}(t) (present at the output of the relative comparators 5 and 5'), the differential amplified output signal v'ₐₘₚ(t) which is present on the output terminals OP1 and OP2 can take three possible values, such as +V_{A}, 0 and -V_{A}. In particular, for positive values of the input signal vᵢₙ(t), the amplified output signal v'ₐₘₚ(t) can range between +V_{A} and 0, while such signal v'ₐₘₚ(t) takes values between 0 and -V_{A}, for negative values of the same input signal vᵢₙ(t).

Consequently, for low levels of the audio input signal vᵢₙ(t), the audio signal v'ₐₘₚ(t) outputted by the ternary amplifier 100' approximates the zero value. Therefore, the spectrum of such output signal v'ₐₘₚ(t) has a fundamental component in the baseband, while the further frequency components are negligible. Therefore, advantageously, it is possible to avoid the filtering of such components at the high frequencies.

It shall be noted that both the amplifier device 100 and the amplifier device 100' can be integrated on one or more semiconductor material chip (for example, silicon), by employing integration techniques (for example, lithographic techniques) that are known to those skilled in the art.

With reference to the functioning of the mobile telephone 200 of Fig. 1, during a telephonic communication, a signal radio which is present at the antenna 10 is received by the transceiver stage 20 which transfers it, suitably processed, to the audio unit 30, in which the input signal vᵢₙ(t) is processed by the amplifier device 100 of Fig. 2.

The input signal vᵢₙ(t) is compared in the first and second nodes N1 and N2 with the amplified audio signal vₐₘₚ(t), which is feedbacked through a first L1 and a second L2 lines. In particular, an error signal vₑ(t) obtained from the difference between the input signal vᵢₙ(t) and the amplified audio signal vₐₘₚ(t), that is vₑ(t) = vᵢₙ(t)- vₐₘₚ(t), is integrated only once by the integrator circuit 101, so as to generate the integrated signal vᵢₙₜ(t).

Starting from the integrated signal vᵢₙₜ(t) and the triangular wave signal vₜᵣ(t), the PWM modulator 102 generates the modulated signal v_{PWM}(t) which is suitably processed by the driving circuit 103. The driving circuit 103 controls the output amplifier 104 which produces the amplified signal vₐₘₚ(t) which is subjected to the filtering by the filter 105. Therefore, the output signal vₒᵤₜ(t) which is present at the terminals O1 and O2 is supplied to the loudspeaker 40 of the mobile telephone 200.

It shall be noted that the feedback which is present in the amplifier device 100, allows reducing the effects of the noises on the supply V_{A} and the non-ideality of both the output amplifier 104 and the triangular wave generator 4. Furthermore, such feedback allows having a band gain of the amplifier device 100 which is equal to G = - R/R1. In the case of the amplifier device with a ternary configuration 100' shown in Fig. 4, the gain G' is - R2/R3.

### Advantages

It is important to notice that the use of the integrator circuit 101 (or 101'), such as to perform an individual integration of the signal which is present at the input thereof, before transferring it to the amplifier stage 300 (or 300'), has particular advantages in regard to reduction of the distortions on the amplified signal vₐₘₚ(t), thus on the output signal vₒᵤₜ(t).

In fact, the Applicant noticed that, following the trend of the prior art teachings, suggesting to increment the number of integrators which are present in the integrator stage which precedes the PWM modulator, an undesired increasing distortion phenomenon occurs, as the number of employed integrators increases. The trend of the prior art is to use more than one integrator (typically, from two to four), since by increasing the number of integrators also the loop gain increases and, as it shall be apparent to those skilled in the art, this involves a higher rejection of the low frequency noises, such as those originating from the supplies, and a higher reduction of the distortions introduced by both the output amplifier stage and the non-perfect linearity of the triangular wave. In particular, these noises seem to reduce as the number of integrators increases, thereby as the filtering order increases.

As mentioned before, the Applicant noticed that by increasing the number of integrators, another type of distortion is made more significant, which is called herein below "distortion from PWM modulation". According to a possible interpretation, the distortion from PWM modulation is due to the fact that the feedbacked signal consists in a modulated PWM signal which brings both a useful signal component (in band), and high frequency noises (of about the frequency of the triangular wave signal and the harmonics thereof), these noises are composed by signals which are related to the frequency of the analog input signal to be amplified.

According to this possible explanation, such noises make so that the signal at the input of the comparator which is employed for the PWM modulation is no more a pure sinusoid, but is the sum of a sinusoidal signal and the high frequency noises. The latter signal sum is, in turn, compared to the triangular wave in order to generate a PWM. It is possible to demonstrate that the application of a PWM modulation on a non-pure sine wave generates a distortion or spurious signals at band.

It has been noticed that the use of only one integrator, such as to perform an individual integration operation, highly reduces the effect of the noises due to the distortion from PWM modulation. Fig. 5 shows the results of a simulation carried out by the applicant with which the behaviour of a closed loop amplifier device such that one 100 of Fig. 2 and that relative to an amplifier device employing two cascade integrators is simulated. For this simulation, the distortion phenomena due to the output amplifier 104 and the non-linearity of the triangular wave have been assumed as being absent.

The graph of Fig. 5 shows the curves relative to the distortion due to the PWM modulation for the amplifier device 100 of Fig. 2 (Curve A) and for an amplifier device employing two integrators (Curve B). As it results from Fig. 5, the amplifier device 100 has a distortion from PWM modulation which is lower than that occurring for the amplifier device having two integrators.

The Applicant noticed that it is possible, with the currently available technologies, to reduce the distortions due to the amplifier stage following the integrator, and therefore that the distortion due to the PWM modulation could result to be preponderant. As it has been illustrated before, by performing only one integration operation, also this type of distortion is considerably reduced.

Another advantage related to the selection of an integrator circuit 101 or (101') which performs an individual integration is that the consumption by the integrator circuit results to be limited, thereby obtaining an increase of the efficiency of the whole amplifier device 100 or 100' compared to that which can be achieved with amplifier devices provided with more amplifiers of the prior art.

To the embodiments of the system and the device described above, those of ordinary skill in the art, in order to meet contingent needs, will be able to make modifications, adaptations, and replacements of elements with other functionally equivalent ones, without departing from the scope of the following claims.

## Claims

1. A device (100, 100') comprising:
an input for an electrical signal (vₑ(t));
an integrator stage (101) connected to said input in order to provide an integrated signal (vᵢₙₜ(t));
an amplifier stage (300, 300') electrically coupled to the integrator stage (101) in order to receive said integrated signal (vᵢₙₜ(t); vᵢₙₜ₁(t)) and to provide an output signal (vₒᵤₜ(t); v'ₐₘₚ(t));
**characterized in that:**
said amplifier stage is such as to introduce a distortion on said output signal below 0.2 %;
the integrator stage (101) is such that the integrated signal is obtained from an individual integration operation of said electrical signal.

2. The device (100, 100') according to claim 1, wherein said device is feedbacked so as to have a closed loop configuration.

3. The device (100, 100') according to claim 1 or 2, wherein said device is a class D amplifier.

4. The device (100, 100') according to claim 1, wherein said integrator stage comprises an individual integrator circuit (101).

5. The device (100, 100') according to claim 1 or 4, wherein said integrator stage (101) comprises:
a first operational amplifier (3) provided with an output (OUT+; OUT-) for the integrated signal;
at least one feedback capacitor (C) connected between said input for the electrical signal (vₑ(t)) and said output (OUT+; OUT-) for the integrated signal.

6. The device (100, 100') according to claim 5, wherein said integrator stage is of the differential type, and:
said input for the electrical signal (vₑ(t)) comprises a non-inverting input terminal (I+) and an inverting input terminal (I-);
said output for the integrated signal comprises a non-inverting output terminal (OUT+) and an inverting output terminal (OUT-).

7. The device (100, 100') according to claim 1, wherein the amplifier stage (300, 300') comprises at least one PWM modulator (102, 102') connected to the integrator stage in order to provide a modulated signal (v_{PWM}(t); v_{1PWM}(t)) starting from said integrated signal (vᵢₙₜ(t); vᵢₙₜ₁(t)).

8. The device (100, 100') according to claim 7, wherein said at least one modulator includes:
a generator (4) of triangular wave signal (vₜᵣ(t));
at least one comparator (5) connected to said generator and to the integrator stage so as to compare the integrated signal (vᵢₙₜ(t); vᵢₙₜ₁(t)) and the triangular wave signal, and to provide said modulated signal.

9. The device (100, 100') according to claim 1, wherein the amplifier stage comprises an output amplifier (104) provided with a respective output (OP1, OP2) for an amplified signal (vₐₘₚ(t); v'ₐₘₚ(t))).

10. The device (100, 100') according to claims 2 and 9, further comprising:
at least one feedback line (L1, L2) connected between said output (OP1, OP2) of the amplifier stage and said input for the electrical signal (vₑ(t)), in order to input to the device said amplified signal (Vₐₘₚ(t); v'ₐₘₚ(t));
at least one input terminal (1, 2) for an input signal (vᵢₙ(t));
at least one comparison node (N1, N2) electrically connected to the at least one input terminal (1, 2) and to said input in order to provide the electrical signal (vₑ(t)) representative of a difference between the input signal (vᵢₙ(t)) and said amplified signal (vₐₘₚ(t); V'ₐₘₚ(t)) transferred in feedback.

11. The device (100, 100') according to claim 9, wherein said output amplifier (104) is a class D amplifier.

12. The device (100, 100') according to claims 7 and 9, wherein said amplifier stage (300, 300') comprises at least one driving circuit (103; 103') of the output amplifier (104) connected to said at least one PWM modulator.

13. The device (100, 100') according to claim 12, wherein said at least one driving circuit is adapted to generate the activation signals starting from the modulated signal (v_{PWM}(t); v_{1PWM(}t)).

14. The device (100) according to claim 9, further comprising a filtering stage (105) connected to said output (OP1, OP2) for the amplified signal (vₐₘₚ(t)).

15. The device (100) according to claim 1, wherein said device is of the differential type.

16. The device (100) according to at least one of the preceding claims, wherein the amplifier stage (300) introduces on said output signal a distortion below 0.1% in the case it has an open loop structure.

17. The device (100, 100') according to at least one of the preceding claims, wherein the generator (4) of triangular wave signal (vₜᵣ(t)) has a linearity such as to introduce a distortion on said output signal below 0.2% or, more preferably, below 0.1% in the case it has an open loop structure.

18. The device (100, 100') according to at least one of the preceding claims, wherein said output amplifier (104) produces a distortion on said output signal below 0.2 % or, more preferably, 0.1% in the case it has an open loop structure.

19. Electronic system (200) comprising:
a device (100, 100') to provide an output signal (vₒᵤₜ(t); v'ₐₘₚ(t));
a load (40) to which the output signal is provided;
**characterized in that** said device is implemented in accordance to at least one of the claims 1 to 18.
